## Europäisches Patentamt
## European Patent Office
## Office européen des brevets

(11) Publication number: **0 071 303**
**B1**

(12) **EUROPEAN PATENT SPECIFICATION**

(45) Date of publication of patent specification: **13.11.85**

(21) Application number: **82200921.3**

(22) Date of filing: **20.07.82**

(51) Int. Cl.⁴: **H 05 K 13/04,** H 01 L 21/68

(54) **Method of and device for positioning electrical and or electronic components on a substrate.**

(30) Priority: **29.07.81 NL 8103574**

(43) Date of publication of application:
**09.02.83 Bulletin 83/06**

(45) Publication of the grant of the patent:
**13.11.85 Bulletin 85/46**

(84) Designated Contracting States:
**AT BE CH DE FR GB IT LI NL SE**

(56) References cited:
**EP-A-0 013 979**
**EP-A-0 016 368**
**GB-A-2 034 613**
**US-A-4 267 003**

(73) Proprietor: **N.V. Philips' Gloeilampenfabrieken
Groenewoudseweg 1
NL-5621 BA Eindhoven (NL)**

(72) Inventor: **Claeskens, Lous Victor
c/o INT. OCTROOIBUREAU B.V. Prof. Holstlaan 6
NL-5656 AA Eindhoven (NL)**
Inventor: **Van de Ven, George
c/o INT. OCTROOIBUREAU B.V. Prof. Holstlaan 6
NL-5656 AA Eindhoven (NL)**

(74) Representative: **Hartung, Edgar Erwin et al
INTERNATIONAAL OCTROOIBUREAU B.V. Prof.
Holstlaan 6
NL-5656 AA Eindhoven (NL)**

## Description

The invention relates to a method of positioning electrical and/or electronic components on a substrate in which a number of components is simultaneously transferred from a pick-up position to a mounting position in order to be positioned on the substrate.

The increasing miniaturization in the electronics industry has given rise to the development of plate-shaped or block-shaped components devoid of connection wires, that is to say, components which do not comprise the conventional comparatively long radial or axial connection wires.

These components without connection wires, also referred to as "chip-type" components, either comprise contact areas on opposite faces or sides, such as capacitors, resistors, coils, or short connection studs, such as diodes and transistors. The components are arranged on a substrate comprising a track pattern, glue or solder paste being locally applied to the track side thereof. The components have dimensions of the order of a few millimeters, for example, 3.2 × 1.6 mm. In view of the small dimensions of the components and the density of the track pattern, the components must be very accurately positioned with respect to the tracks on the substrate.

A method of the kind set forth is known from U.K. Patent Application 20 25 910. According to the known method, the components are presented at the pick-up position in the same pattern as that in which they are to be positioned on the substrate. This pattern has to be adapted to different substrates. This known method is very dependent on the substrate and on the product and is not very flexible, which means that it is difficult to adapt the method to different substrates. The conversion times are comparatively long. Moreover, the components cannot be presented from a strip-shaped package like a tape, because the necessary space is not available.

The invention has for its object to provide an improved method according to which the components are picked up, transferred and positioned on the substrate in a simple, quick and accurate manner.

This object in accordance with the invention is achieved mainly in that the components are presented at the pick-up position in a first regular pattern with a regular pitch between components and are picked up in this first pattern, the picked up components, prior to their positioning on the substrate, being displaced with respect to one another and arranged in a modified pattern and ultimately being positioned on the substrate in the modified pattern, which deviates from the first regular pattern of the components in the pick-up position and which corresponds to the desired pattern of the components on the substrate.

Using the method in accordance with the invention, components can be presented and picked up in a simple pattern with a minimum pitch between components. This pattern is permanent and remains unmodified, even for the positioning of the components on substrates comprising different track patterns and having different dimensions. The transfer of the components is performed very efficiently, because the transport time is used to arrange the components in the desired pattern. Moreover, due to the permanent unmodified pattern in which the components are presented, common devices, for example, the device for the feeding and presentation of the components, the device for the transfer of the components and other devices can be simply designed as a standard mechanism, regardless of the dimensions of the substrates and the track patterns. The components are positioned on the substrate either in rapid succession or groupwise, but preferably simultaneously.

A preferred embodiment of the method in accordance with the invention is characterized in that during their transfer to the mounting positions the components are displaced over the equal distances along straight parallel paths in a first stage of movement and are subsequently displaced over different distances in a second stage of movement. In the first stage of movement the components can be subjected to a common operation, for example, simultaneous alignment; in the second stage the components are arranged in the desired pattern.

In a further preferred embodiment of the method in accordance with the invention in the second stage of movement the components are positioned independently of one another in a direction extending transversely of the transport direction. In this way a small overlap of the positioning zones of the components on the substrate in the transverse direction can be obtained.

In a further preferred embodiment of the method in accordance with the invention components are presented in a line-pattern in the pick-up position. In this embodiment, the components can be presented and picked up in the simplest manner, for example, in one row.

A further preferred embodiment of the method in accordance with the invention is characterized in that a fixing medium is applied to all the components simultaneously on the paths of the first stage of movement of the components. As a result of the direct application of the fixing medium to the components on said paths, the same simple device can be used for the application of a fixing medium to components to be positioned on different substrates. For the fixing medium glue, a glue component, an activator, solder paste etc. can be used.

With the method in accordance with the invention, substrates can be provided with components in a fast, cheap and reproducible manner, the transport paths of the components being comparatively short and mainly rectilinear.

The invention also relates to a device for performing the method, comprising a frame, a transfer mechanism with pick-ups, a drive mechanism and a carrier for a substrate; the device in accordance with the invention is characterized in that the transfer mechanism comprises a given number of transfer arms, each of which comprises a pick-up, said transfer arms being slidable with respect to one another in a common guide means, being displaceable between a pick-up position and a mounting position, and cooperating with abutments which define the pick-up position and the mounting position of the individual transfer arms. As a result of this combination of a number of transfer arms which are slidable with respect to one another by a common drive element, a comparatively simple and compact construction is obtained. The device in accordance with the invention offers a high production rate for a comparatively low investment.

A preferred embodiment of the device in accordance with the invention is characterized in that the common guide means is formed by a carriage which is coupled to the drive mechanism and in which the transfer arms are slidably supported. The slide permits the simple and efficient common displacement of all the transfer arms simultaneously as well as relative displacements of the transfer arms with respect to one another.

Another preferred embodiment of the device in accordance with the invention is characterized in that at least the abutments which define the mounting position of the transfer arms are provided on an exchangeable program plate which is common to all transfer arms. Merely by exchanging the program plate, the device can be very quickly and simply converted and adapted to the mounting of components on different substrates. The mounting positions of all the transfer arms are laid down in this program plate by means of the abutments. by simply exchanging the program plate, the mounting positions of all transfer arms can be simultaneously changed. The abutments on the program plate may be fixed, in which case the program plate contains a fixed program. However, the abutments may also be adjustable, in which case the abutments can be adjusted off the device. For the mounting of components on different substrates, different program plates can be stored, one for each substrate.

In another preferred embodiment of the device, in accordance with the invention, the abutments which define the pick-up position of the transfer arms are permanently arranged on the frame with a regular pitch. As a result of this step, a fixed, invariable pick-up position is defined for each transfer arm regardless of the mounting position of the transfer arms and regardless of the various program plates. In the pick-up position of the transfer arms, the positions of the various pick-ups coincide with the pick-up positions of the components to be picked up.

In another preferred embodiment of the device in accordance with the invention, a small transverse displacement of the pick-ups is possible in that the program plate comprises guides for the positioning of the transfer arms and the pick-ups in a direction extending transversely of the direction of movement. As a result of such positioning of the pick-ups, some overlap of the components on the substrate can be realized, viewed in the direction transversely of the slide movement.

Another preferred embodiment of the device in accordance with the invention is characterized in that each guide connects an abutment on the program plate to a catcher element at the entry side of the program plate, the catcher elements being arranged with a regular pitch. Reliable and accurate guiding of the transfer arms and hence of the pick-ups is thus obtained from the entry of the program plate to an abutment which defines the mounting position.

In another preferred embodiment of the device in accordance with the invention, each of the pick-ups on the transfer arms comprises a projection for cooperation with the program plate. Because the pick-ups define the ultimate positions of the components in their mounting position, the most accurate positioning of the components is obtained by the direct cooperation plate and pick-ups.

A further preferred embodiment of the device in accordance with the invention is characterized in that each pick-up comprises a suction tube which is rotatably supported in a housing and which is coupled to a pinion meshing with a toothed rack which is cooperable with an abutment on the program plate for rotation of the suction tube. As a result of these steps, the program plate can be simply used to obtain a rotation of the suction tubes and hence a rotation of the components picked up by the suction tubes, about a perpendicular axis.

A final preferred embodiment of the device in accordance with the invention is characterized in that it comprises a mechanism for applying a fixing medium to the components, said mechanism comprising mainly an elongate arm which comprises a number of stamps, said arm being displaceable between a rest position in which the stamps can pick up a quantity of fixing medium, and an operating position in which the stamps can be brought into contact with the lower sides of the picked-up components.

This simple mechanism permits application of a fixing medium to all the components simultaneously, specifically, to the lower sides of the components, whilst the components are still in the same simple pattern in which they have been picked up by the pick-ups. Because this pattern is independent of the substrate, the described mechanism is not limited to a given substrate or a given track pattern, so it need not be exchanged when the program plate is exchanged.

An embodiment of the method and of the apparatus according to the invention will be described in detail hereinafter with reference to the drawings.

Figure 1 shows diagrammatically an apparatus for mounting electrical and/or electronic components on a substrate.

Figure 2 is a diagrammatic longitudinal sectional side view, taken along the line II—II in Figure 3, of a transfer device in the pick-up position, which tranfer device forms part of the apparatus shown in Figure 1.

Figure 3 is a sectional view of the transfer device, taken along the line III—III in Figure 2.

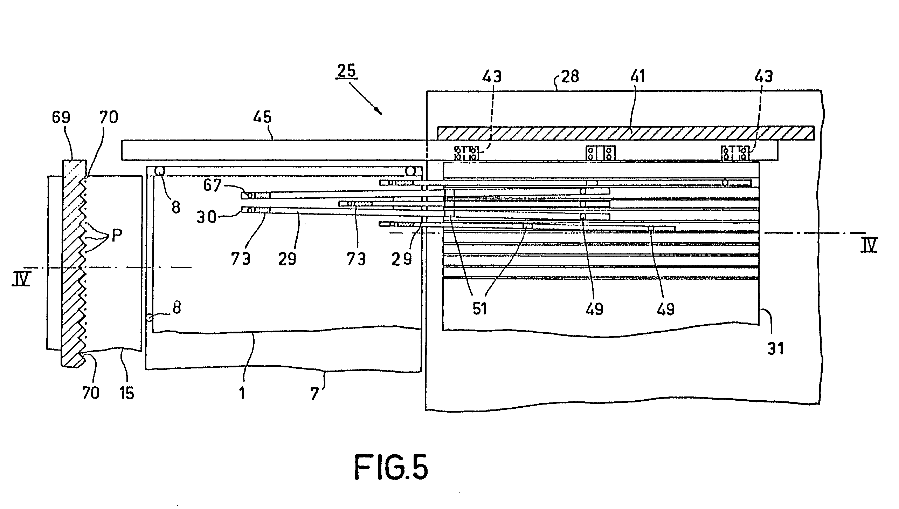

Figure 4 is a sectional view of the transfer device in the mounting position, taken along the line IV—IV in Figure 5.

Figure 5 is a sectional view of the transfer device, taken along the line V—V in Figure 4.

Figure 6 is an underneath view, on enlarged scale, of a part of the program plate, taken along the line VI—VI in Figure 7.

Figure 7 is a sectional view of the program plate, taken along the line VII—VII in Figure 6.

Figure 8 is a sectional view of a part of a pick-up, taken along the line VIII—VIII in Figure 9.

Figure 9 is a partial cross-sectional view of the pick-up, taken along the line IX—IX in Figure 8.

Figure 10 is a longitudinal sectional view, taken along the line X—X in Figure 8, of the pick-up.

Figure 11 shows diagrammatically a mechanism for the application of a fixing medium.

Figure 12 shows a part of the mechanism shown in Figure 11.

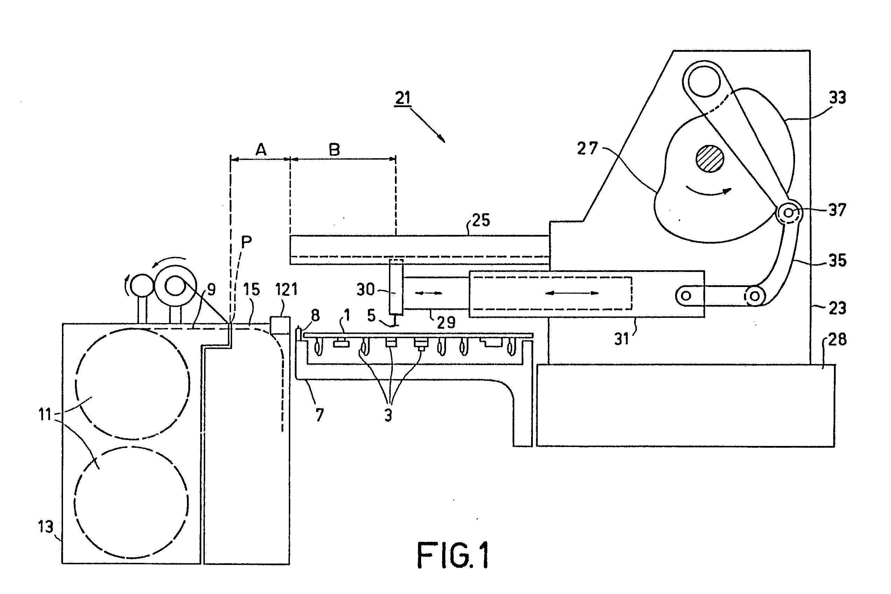

The reference numeral 1 in Figure 1 denotes a substrate, for example, a printed-circuit board whose lower side has already been provided with conventional components 3 having lead-outs which are arranged in holes in the substrate. A large number of further components 5 which are very small and which do not have lead-outs have to be mounted on the top side of the substrate. The dimensions of this type of component, also referred to as a "chip", are of the order of a few millimeters and the components must be very accurately positioned on the substrate with a very small spacing between them. A frequently occurring size is 3.2 × 1.6 mm. The substrate 1 is supported by a substrate carrier 7 which comprises positioning elements 8. The components 5 to be positioned are packed in tapes 9 provided with sprocket holes, the components being loosely positioned in openings in the tapes which are closed at the lower side by a lower foil and at the upper side by a cover foil.

A number of such tapes is wound onto reels 11 in a holder 13. The number of reels present in the holder 13 depends on the requirements. Thirty-two reels is a customary number which can be rotatably arranged in the holder 13 at two levels. The tapes 9 extend from the reels 11 to a device 15 (not shown in detail) for feeding the tapes to a given pick-up position P. In the present embodiment, this device has a 32-fold construction, so that during each cycle thirty-two components 5 are presented. The components 5 are removed from the tapes 9 and are transferred to the substrate 1 by a transfer device 21. The transfer device 21 mainly consists of a frame 23, a transfer mechanism 25, a drive mechanism 27 and the already described substrate carrier 7. These parts are mounted on a frame 28.

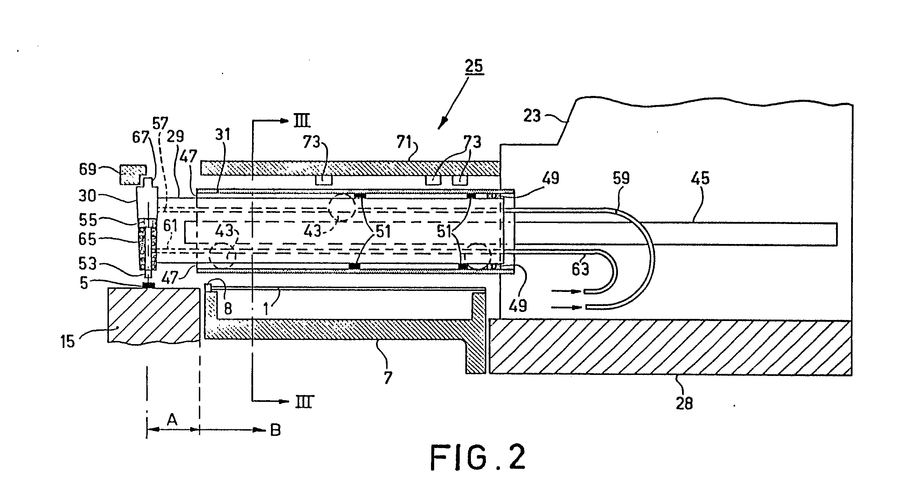

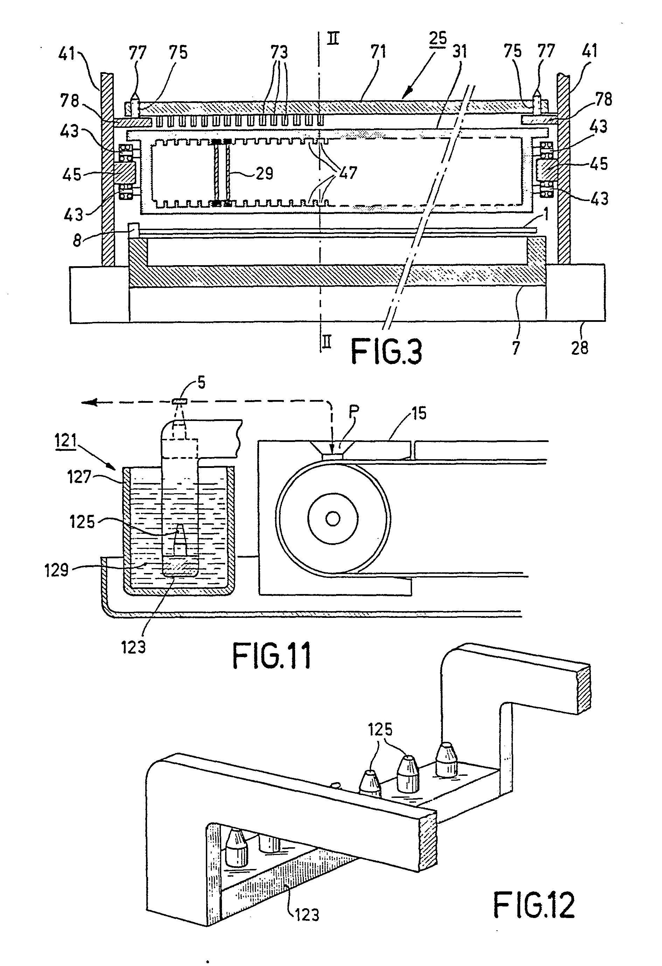

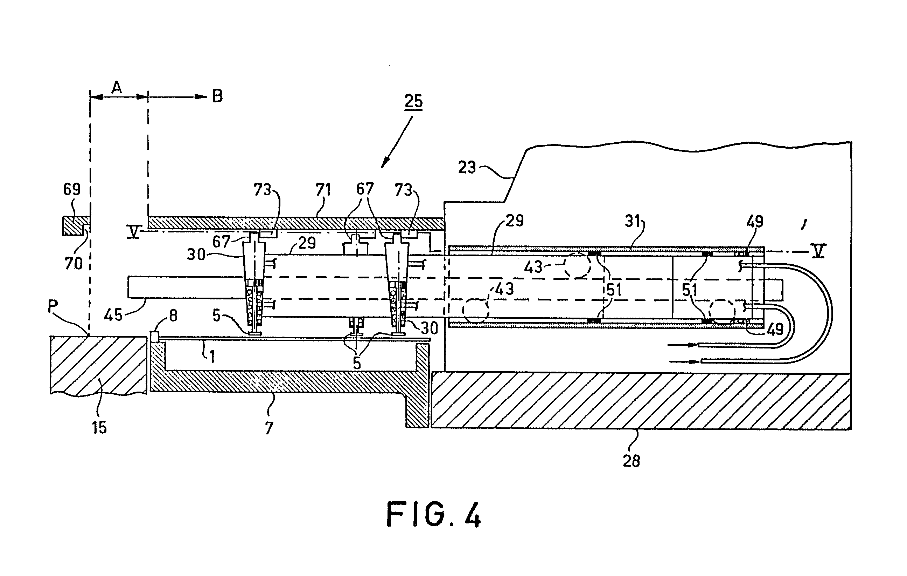

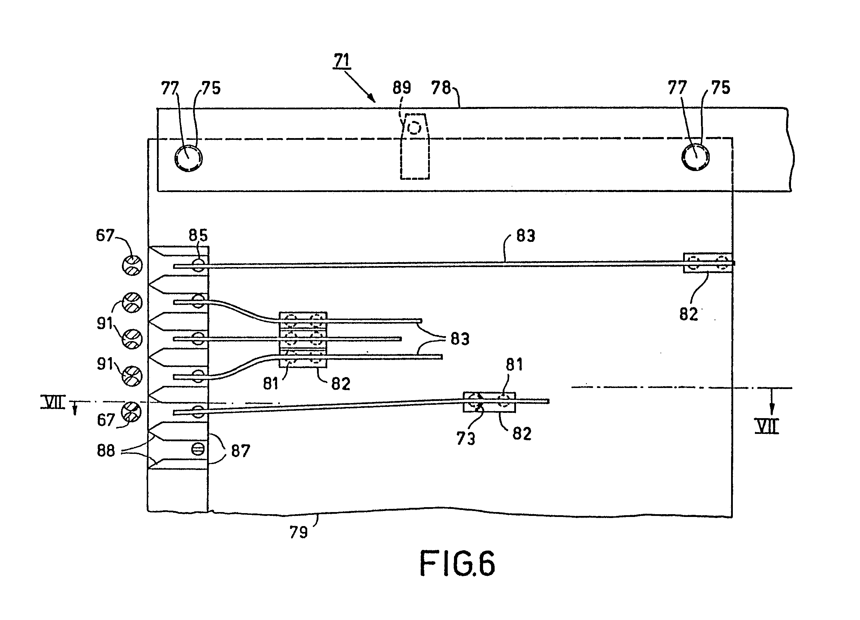

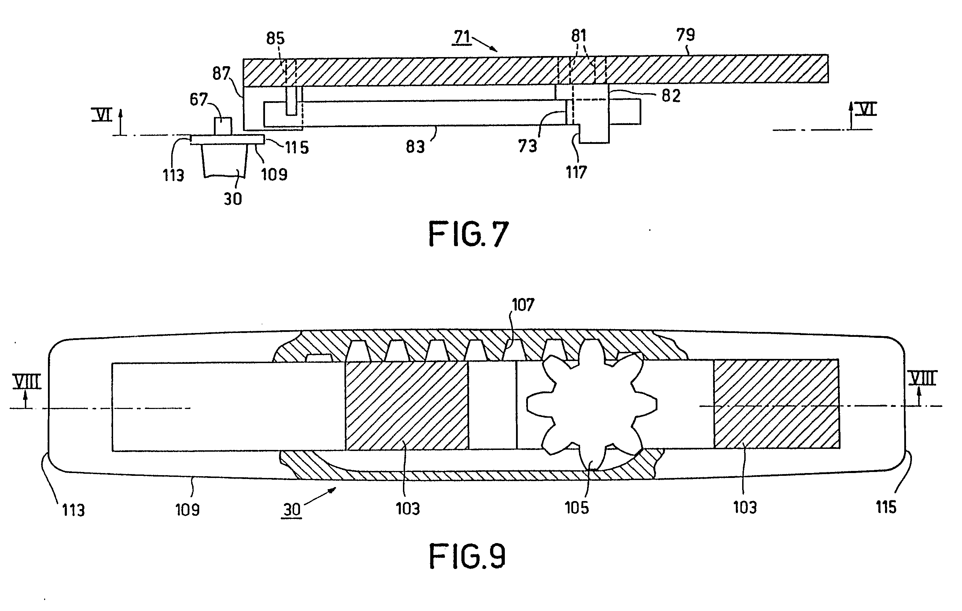

The transfer mechanism 25 comprises a number of transfer arms 29 equal to the number of components to be simultaneously transferred, which amounts to thirty-two in the present embodiment. Each transfer arm 29 comprises a pick-up 30. The transfer arms 29 are independently slidable in a single common carriage 31 which is itself movable in a reciprocating manner in the frame 23. The carriage is driven by the drive mechanism 27 which is shown in Figure 1 and which comprises a motor (not shown), a cam disc 33 and a lever 35 with a cam-follower roller 37. The frame 23 mainly consists of two side walls 41 which are shown in Figure 3. The carriage 31 has a tubular form with a rectangular cross-section and in its reciprocating movement is guided by rollers 43 which are mounted on the sides of the carriage and which run along two rails 45 which are secured on the inner sides of the side walls 41 and which freely project from the frame 23 beyond the carrier 7. The carriage 31 is thus freely movable between the side walls 41. In the sides of the upper and lower walls of the carriage there are provided parallel grooves 47, thirty-two grooves in each wall in the present embodiment. These grooves 47 serve to guide in a sliding manner a corresponding number of transfer arms 29 in cooperation with ball bearings 49 and sliding blocks 51. The ball bearings 49, one at the top and one at the bottom of each transfer arm, ensure that the transfer arms are supported without play at their rear ends. As a result of this supporting, the vertical position of the transfer arms is maintained. The sliding blocks 51 are so proportioned that some play exists between the transfer arms 29 and the carriage 31 in the transverse direction, the transfer arms then pivoting about the ball bearings 49, which define vertical pivot axes. At its end remote from the frame 23 each transfer arm 29 comprises a pick-up 30 which comprises a suction tube 53 in the present embodiment. The suction tube 53 is movable in the vertical direction (Figure 2) by means of a piston 55. Each transfer arm 29 comprises a compressed-air duct 57 which is connected via a flexible tube 59 to a compressed-air source and which communicates with the space in the respective pick-up 30 above the piston 55. Also, in each transfer arm 29 there is provided a vacuum duct 61 which is connected to a vacuum source via a flexible tube 63 and which can be made to communicate with the respective suction tube 53. The suction tube is maintained in a neutral position as shown in Figure 2 by means of a spring 65, acting on the respective piston 55, the respective transfer arm 29 then being in the pick-up position and ready to pick-up a component 5 present in the feed device 15. In this position, a projection 67 on the top end of the respective pick-up 30 abuts against an abutment bar 69 which is provided with recesses 70 (Figure 4) and which acts as a multiple fixed abutment. The reference numeral 71 denotes a program plate which is arranged on the frame 23 in such a manner as to be exchangeable and which comprises stops 73 which are engageable by the projections 67 on the pick-ups 30 to halt the transfer arms 29 in the mounting shown in Figure 4. As is shown in Figure 3 the program plate 71 is accurately positioned with respect to the frame 23 by means of locating holes 75 which cooperate with the locating pins 77. The program plate 71 rests on two elongate supports 78 which are mounted on the side walls 41 of the frame 23. Figures 6 and 7 are an underneath view and a longitudinal sectional view, respectively, on an enlarged scale, of the program plate 71 with the locating holes 75 and the stops 73. The program plate comprises a plate-like body 79 which is provided with bores 81 in which there are secured abutment blocks 82 provided with the stops 73. At its entry side which is remote from the frame 23, the program plate 71 comprises a row of spaced catcher elements 87, between which are formed funnel-shaped guide slots 88. Leaf springs 83 which act as flexible guide elements are secured at one end in the guide slots 88 by means of pins 85 which are each provided with a slot. At the other end, the leaf springs 83 are secured in the abutment blocks 82. The program plate 71 is clamped on the supports 78 by means of clamping elements 89 which can be readily detached and secured. The guide elements 83 cooperate with the projections 67 on the pick-ups 30, each projection comprising a slot 91 for this purpose.

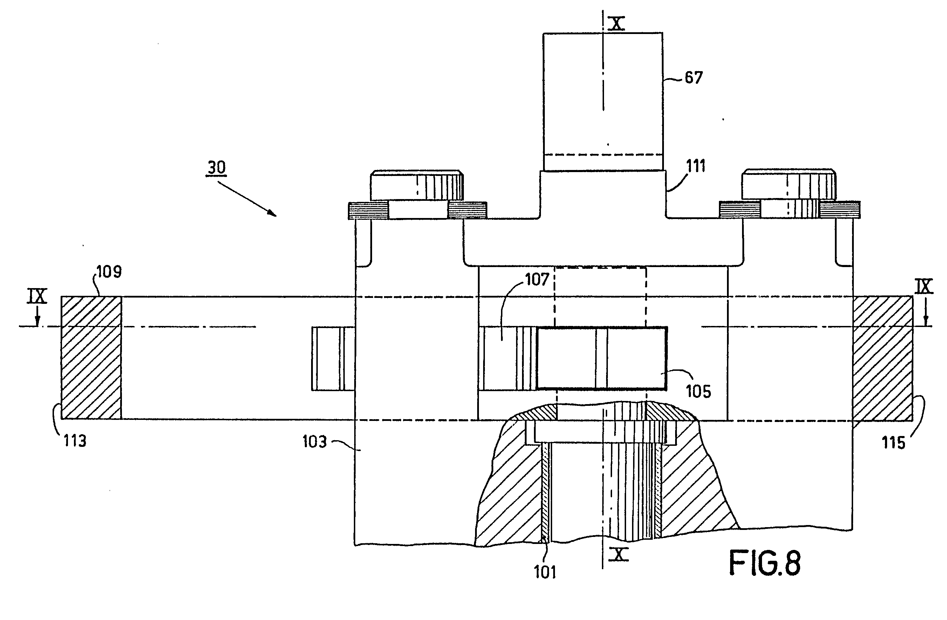

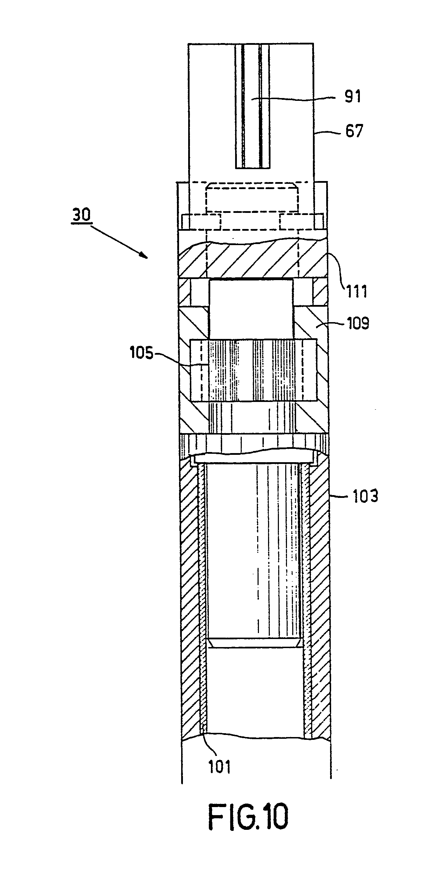

Figures 8, 9 and 10 show, on an enlarged scale, the upper end of a pick-up 30 with a bush 101 which is rotatable in the housing 103 of the pick-up and which is coupled to the suction tube (not shown). The housing 103 has an elongate cross-section in the lateral direction. The bush 101 is coupled to a pinion 105 which meshes with a toothed rack 107 which forms part of a sliding element 109. This sliding element is slidably supported on the housing 103 by means of a cap 111 on which the projection 67 with the slot 91 is formed. The pinion 105 is located between the housing 103, the sliding element 109 and the cap 111. The end faces 113 and 115 of the sliding element 109 act as abutment faces.

Figures 11 and 12 diagrammatically show a mechanism 121 for applying a fixing medium to the lower sides of the components 5 to be positioned. This mechanism comprises mainly an elongate arm 123 which can be swung between a rest position (denoted by solid lines in Figure 11) and an operative position which is denoted by broken lines. The arm 123 carries stamps 125 which are arranged in a row and the number of which equals the number of components to be positioned in one cycle. The mechanism 121 furthermore comprises a stationary elongate container 127 which contains a fixing medium 129. The swinging movements of the arm 123 can be derived from the drive mechanism 27 which is diagrammatically shown in Figure 1. The reference numeral 15 denotes the feeding device which feeds the components to be positioned to the pick-up position P. In the rest position, the arm 123 with the stamps 125 is submerged in the fixing medium 129 in the container 127. During the displacement of the arm 123 from the rest position to the operative position, the stamps pick-up a quantity of fixing medium, contact the lower sides of the stationary components 5 which are supported by the pick-ups 30, deposit a quantity of the fixing medium on the components and return to their rest position. The location of the mechanism 121 is shown diagrammatically in Figure 1.

The cycle of the transfer device will now be described in detail. First, all thirty-two transfer arms 29 with the thirty-two pick-ups 30 must be brought to their pick-up positions. To this end, the carriage 31 is moved towards the abutment bar 69 by the drive mechanism 27. The sliding blocks 51 slide in the grooves 47 of the carriage 31 with an accurately defined friction. The friction is adjusted to a value such that when the carriage 31 is driven, the transfer arms 29 move with it. However, as soon as the projection 67 on the pick-up 30 of a transfer arm 29 contacts the abutment bar 69, that transfer arm and pick-up remain stationary while the carriage 31 continues its movement, the respective sliding blocks 51 and ball bearings 49 remaining stationary in the respective grooves 47 in the carriage 31 during the movement of the carriage.

During the displacement of the carriage 31 to the pick-up position, the transfer arms 29 move forward until all the pick-ups 30 contact the fixed abutment bar 69 through their projections 67, so that they are stationary in their pick-up positions. The projections 67 and the recesses 70 in the abutment bar 69 are so shaped, proportioned and adjusted that in the pick-up position of the transfer arms, the centre lines of the suction tubes 53 pass though the pick-up points P of the components arranged in the pick-up position (Figure 2). Subsequently, the suction tubes 53 are moved downwards by compressed air and the components 5 are picked up and held by the suction tubes 53, which are connected to the vacuum source. After interruption of the compressed-air supply the suction tubes are raised again by the springs 65 and the carriage 31 is moved backwards by the drive mechanism, the transfer arms 29 being taken along with the carriage and the pick-ups 30 thereby moving back as far as the entry side of the program plate 71. All the pick-ups will have then completed a first stage of movement. Along straight parallel paths and over equal distances. At the entry side of the program plate 71 there are provided the catcher elements 87 which form the funnel-shaped guide slots 88 which lead to the adjacent ends of the flexible guide elements 83 (Figure 6). The other end portion of each guide element 53 is secured in an abutment block 82, which by means of the associated stop 73 can halt a pick-up 30 in a mounting position which is exactly above the placement area of the component to be positioned on the substrate. The projections 67 on the pick-ups are guided by the funnel-shaped slots 88 onto the guide elements 83, with the guide elements engaging in the slot 91, in the projections 67, and follow the path of these elements as far as the stops 73, where the transfer arms 29 are halted by engagement of the projections 67 on their pick-ups 30 with the stops 73. The pick-ups will have then completed a second stage of movement B, with or without lateral displacement and over distances which may or may not be equal.

When all the pick-ups 30 have reached the stops 73, the suction tubes 53 are moved down again by means of compressed air and the components 5 are positioned on the substrate 1 after destruction of the vacuum in the suction tubes. Subsequently, the suction tubes are raised again. Finally, the carriage 31 is moved forward again until all the pick-ups 30 again contact the fixed abutment bar 69.

In a practical embodiment of the device for the simultaneous transfer of 32 components, the transfer mechanism comprised 32 transfer arms 29 and a program plate 71 with 32 guide elements 83 and 32 abutment blocks 82. The pitch, i.e. the distance between centres, of the grooves 47 in the carriage 31 and of the transfer arms was 10 mm. The components were presented in one row with a pitch of 10 mm. The width of the transfer arms and the thickness of the pick-ups was 5 mm. The pick-ups had a possible lateral displacement of 5.5 mm in one direction. Therefore, each pick-up could cover a field having a width of 11 mm. The carriage 31 had a maximum useful stroke of 210 mm. Using this device, substrates having maximum dimensions of 120 × 321 mm could be provided with components. The duty cycle amounted to 2.4 seconds. The maximum production rate was 48,000 components per hour. The positioning accuracy amounted to ± 0.05 mm.

In the embodiment shown (Figure 1), the components are supplied in a tape. However, the components can alternatively be supplied in any other suitable manner, for example, in magazines or in bulk; it is necessary only that the components are presented in a fixed pattern in the pick-up position.

When pick-ups of the construction shown in Figures 8, 9 and 10 are used a rotary movement can be imparted to the suction tubes if rotation of the relevant components is desirable. As is shown diagrammatically in Figure 7, the abutment blocks 82 then each comprise a second abutment 117 for cooperation with an abutment face 115 on the sliding element 109 of the respective pick-up 30 in order to effect a rotational movement of the pinion 105 and hence a rotational movement of the suction tube of the pick-up. In order to give a choice of rotary movements of the suction tubes through an angle of 90°, 180° or 270°, suitably adapted abutment blocks can be mounted on the program plate. The suction tubes can each be arranged to rotate against the force of a spring which serves to return the suction tube to the starting position. The suction tubes can alternatively be arranged to be returned to the starting position by means of further abutments on the abutment bar 69 which further abutments, like the abutments 117, on the abutment block 82, can each cooperate with an end face 113 of the sliding element 109 of a respective one of the pick-ups 30.

The substrate can be locally provided with an adhesive in known manner, for example, glue, solder paste etc. However, this requires a special tool such as a silk-screening device or a multiple stamp which is adapted to the pattern of the substrate. By applying the fixing medium to the components by means of the mechanism shown in Figures 11 and 12, the fixing medium can be simply and cheaply applied. This mechanism is not limited to a given substrate and need not be exchanged.

In the described embodiment, the fixed abutments which define the pick-up positions of the pick-ups are provided on a single abutment bar. Obviously, individual fixed abutments can alternatively be used.

The device described comprises pick-ups which comprise suction tubes. However, grippers or combinations of a suction tube and an alignment gripper can alternatively be used. If necessary or desirable, the components can be aligned after pick-up, individually by means of alignment grippers or together by means of a suitable device.

The program plate comprises flexible guide elements. Rigid guide elements such as grooves or ribs can alternatively be used.

Ultimately, facilities can be provided to test whether or not all the pick-ups have indeed picked up a component, so that any missing component can be supplied independently. During the displacement of the components to the mounting positions, the suction tubes remain connected to the vacuum source. At each suction tube the vacuum is measured. If the vacuum in any suction tube is below a given level, it is assumed that no component is attached to that suction tube will not perform a vertical stroke for the positioning of the component. For this purpose each suction tube comprises an electronically controlled valve which is capable of admitting the compressed air for the vertical stroke. After the other suction tubes have completed their cycle, all the suction tubes return to their pick-up positions. Subsequently, only the suction tube which has not positioned a component picks up a component and positions it on the substrate. The other suction tubes then do not make a vertical stroke during pick-up and positioning.

The substrate which is shown diagrammatically in Figure 1 has already been provided with conventional components whose lead-outs are positioned in holes in the substrate. Obviously the method and the device in accordance with the invention also enables components without connection wires to be positioned in a similar manner on substrates without holes.

## Claims

1. A method of positioning electrical and/or electronic components on a substrate, in which a given number of components is simultaneously transferred from a pick-up position to a mounting position in order to be positioned on the substrate, characterized in that the components are presented at the pick-up position in a first regular pattern with a regular pitch between components and are picked-up in this first pattern, the picked-up components, prior to their positioning on the substrate, being displaced with respect to one another and arranged in a modified pattern and ultimately being positioned on the substrate in the modified pattern, which deviates from the first regular pattern of the components in the pick-up position and which corresponds to the desired pattern of the components on the substrate.

2. A method as claimed in Claim 1, characterized in that during their transfer to the mounting positions the components are displaced over the equal distances along straight parallel paths in the first stage of movement and are subsequently displaced over different distances.

3. A method as claimed in Claim 1 or 2, characterized in that in the second stage of movement the components are positioned independently of one another in a direction extending transversely of the transport direction.

4. A method as claimed in any of Claims 1 to 3, characterized in that the components are presented in a line at the pick-up position pattern.

5. A method as claimed in any of the preceding Claims, characterized in that a fixing medium is applied to all the components simultaneously on the paths of the first stage of movement of the components.

6. A device for performing the method claimed in any of Claims 1 to 5, comprising a frame, a transfer mechanism (25) with pick-ups (30), a drive mechanism (27) and a carrier (7) for a substrate, characterized in that the transfer mechanism comprises a given number of transfer arms (23), each of which comprises a pick-up (30), said transfer arms being slidable with respect to one another in a common guide means (31), being displaceable between a pick-up position and a mounting position, and cooperating with abutments (69, 82) which define the pick-up position and the mounting position of the individual transfer arms.

7. A device as claimed in Claim 6, characterized in that the common guide means is formed by a carriage (31) which is coupled to the drive mechanism (27) and in which the transfer arms (29) are slidably supported.

8. A device as claimed in Claim 6 or 7, characterized in that at least the abutments (82) which define the mounting positions of the transfer arms are provided on an exchangeabe program plate (71) which is common to all the transfer arms.

9. A device as claimed in Claim 6, 7 or 8, characterized in that the abutments (69) which define the pick-up position of the transfer arms are permanently arranged on the frame with a regular pitch.

10. A device as claimed in Claim 8 or 9, characterized in that the program plate (71) comprises guides (83) for the positioning of the transfer arms (29) and the pick-ups (30) in a direction extending transversely of the direction of movement of the carriage (31).

11. A device as claimed in Claim 10, characterized in that each guide (83) connects an abutment (82) on the program plate to a catcher element (87) at the entry side of the program plate (71), the catcher elements being arranged with a regular pitch.

12. A device as claimed in any of Claims 7 to 12, characterized in that each of the pick-ups (30) on the transfer arms (29) comprises a projection (67) for cooperation with the program plate.

13. A device as claimed in any of Claims 8 to 12, characterized in that each pick-up comprises a suction tube (53) which is rotatably supported in a housing (103) and which is coupled to a pinion (105) meshing with the rack (107) which is cooperable with an abutment on the program plate for rotation of the suction tube.

14. A device as claimed in any of Claims 6 to 13, characterized in that it comprises a mechanism for applying a fixing medium (129) to the components (5), said mechanism comprising an elongate arm (123) which comprises a number of stamps (125) said arm being displaceable between a rest position in which the stamps can pick up a quantity of fixing medium, and an operating position in which the stamps can be brought into contact with the lower sides of the picked-up components (5).

## Patentansprüche

1. Verfahren zur Positionierung von elektrischen und/oder elektronischen Bauelementen auf einem Träger, wobei eine bestimmte Anzahl Bauelemente gleichzeitig aus einer Aufnahmelage in eine Montagelage übertragen und auf dem Träger positioniert werden, dadurch gekennzeichnet, dass die Bauelemente in der Aufnahmelage in einem ersten regelmässigem Muster mit einem regelmässigen Abstand zwischen den Bauelementen angeboten und in diesem ersten Muster aufgenommen werden, die aufgenommenen Bauelemente vor deren Positionierung auf dem Träger relativ zueinander verschoben und in ein geändertes Muster gebracht werden und letzten Endes in dem geänderten Muster, das von dem ersten regelmäßigen Muster der Bauelemente in der Aufnahmelage abweicht und dem gewünschten Muster der Bauelemente auf dem Träger entspricht, auf diesem Träger positioniert werden.

2. Verfahren nach Anspruch 1, dadurch gekennzeichnet, dass die Bauelemente während ihrer Übertragung in die Montagelagen über gleiche Abstände längs gerader paralleller Strecken in einem ersten Bewegungsvorgang verschoben werden und daraufin in einem zweiten Bewegungsvorgang über unterschiedliche Abstände verschoben werden.

3. Verfahren nach Anspruch 1 oder 2, dadurch gekennzeichnet, dass die Bauelemente unabhängig voreinander in dem zweiten Bewegungsvorgang in einer Richtung quer zu der Transportrichtung gegenübereinander ausgerichtet werden.

4. Verfahren nach einem der Ansprüche 1 bis 3, dadurch gekennzeichnet, dass die Bauelemente in der Aufnahmelage in einem linienförmigen Muster angeboten werden.

5. Verfahren nach einem der vorstehenden Ansprüche, dadurch gekennzeichnet, dass auf den Strecken des ersten Bewegungsvorgangs der Bauelemente auf allen Bauelementen gleichzeitig ein Haftmittel angebracht wird.

6. Vorrichtung zum Durchführen des Verfahrens nach einem der Ansprüche 1 bis 5 mit einem Rahmen, einem Übertragungsmechanismus (25) mit Aufnehmern (30), einem Antriebmechanismus (27) und einer Tragvorrichtung (7) für einen Träger, dadurch gekennzeichnet, dass der Übertragungsmechanismus (25) eine Anzahl Übertragungsarme (29) mit je einem Aufnehmer (30) aufweist, wobei die Übertragungsarme relativ zueinander in einem gemeinsamen Führung zwischen einer Aufnahmestellung und einer Montagestellung bewegbar sind und mit Anschlägen (69, 82), welche die Aufnahmestellung und Montagestellung der einzelnen Übertragungsarme bestimmen, zusammenarbeiten.

7. Vorrichtung nach Anspruch 6, dadurch gekennzeichnet, dass die gemeinsame Führung durch einen Schlitten (31) gebildet ist, der mit dem Antriebsmechanismus (27) gekuppelt ist und in dem die Übertragungsarme (29) verschiebbar gelagert sind.

8. Vorrichtung nach Anspruch 6 oder 7, dadurch gekennzeichnet, dass wenigstens die Anschläge (82), welche die Montagestellung der Übertragungsarme bestimmem, auf einer allen Übertragungsarmen gemeinsamen austauschbaren Programmplatte (71) angeordnet sind.

9. Vorrichtung nach Anspruch 6, 7 oder 8, dadurch gekennzeichnet, dass die Anschläge (69), welche die Aufnahmestellungen der Übertragungsarme bestimmen, mit regelmässigem Mittenabstand ortsfest auf dem Rahmen angeordnet sind.

10. Vorrichtung nach Anspruch 8 oder 9, dadurch gekennzeichnet, dass die Programmplatte (71) Führungselemente (83) zum Positionieren der Übertragungsarme (29) und der Aufnehmer (30) in einer Richtung quer zur Bewegungsrichtung des Schlittens (30) aufweist.

11. Vorrichtung nach Anspruch 10, dadurch gekennzeichnet, dass jeder Führungselement (83) einen Anschlag (82) auf der Programmplatte mit einem Auffangelement (87) auf der Eingangsseite der Programmplatte (71) verbindet, wobei die Auffangelemente mit einem regelmässigen Mittenabstand angeordnet sind.

12. Vorrichtung nach einem der Ansprüche 7 bis 11, dadurch gekennzeichnet, dass jeder der Aufnehmer (30) auf den Übertragungsarmen (29) mit einem Nocken (67) zum Zusammenarbeiten mit der Programmplatte versehen ist.

13. Vorrichtung nach einem der Ansprüche 8 bis 12, dadurch gekennzeichnet, dass jeder Aufnehmer eine Pipette (53) aufweist, die in einem Gehäuse (103) drehbar gelagert und mit einem Ritzel (105) gekuppelt ist, das mit einer Zahnstange (107) im Eingriff ist, die mit einem Anschlag auf der Programmplatte zur Drehung der Pipette zusammenarbeiten kann.

14. Vorrichtung nach einem der Ansprüche 6 bis 13, gekennzeichnet durch einen Mechanismus zum Anbringen eines Haftmittels (129) auf den Bauelementen (5), wobei dieser Mechanismus einem länglichen Arm (123) aufweist, der mit einer Anzahl Stempel (125) versehen ist, wobei der Arm zwischen einer Ruhelage, in der die Stempel eine Menge des Haftmittels aufnehmen können, und einer Betriebslage, in der die Stempel mit der Unterscheite der aufgenommenen Bauelemente (5) in Berührung gebracht werden können, bewegbar ist.

**Revendications**

1. Procédé de positionnement de composants électriques et/ou électroniques sur un substrat, suivant lequel plusieurs composants sont transférés simultanément à partir d'une position de réception vers une position de montage pour être positionnés sur le substrat, caractérisé en ce que les composants sont présentés à la position de réception dans une première configuration régulière avec un écartement régulier entre les composants et en ce qu'ils sont saisis dans cette première configuration, alors qu'avant leur positionnement sur le substrat, les composants saisis sont déplacés les uns par rapport aux autres et sont arrangés dans une configuration modifiée et que, finalement, ils sont positionnés sur le substrat dans la configuration modifiée qui diffère de la première configuration régulière des composants dans la position de réception et qui correspond à la configuration souhaitée des composants sur le substrat.

2. Procédé selon la revendication 1, caractérisé en ce qu'au cours de leur transfert vers les positions de montage, les composants sont déplacés sur des distances égales et suivant des trajets parallèles droits dans une première phase de mouvement et sont déplacés ensuite sur des distances différentes dans une seconde phase de mouvement.

3. Procédé selon l'une des revendications 1 et 2, caractérisé en ce que dans la seconde phase de mouvement, les composants sont positionnés indépendamment les uns des autres dans une direction perpendiculaire à la direction de transport.

4. Procédé selon l'une des revendications 1 à 3, caractérisé en ce que les composants sont présentés dans une configuration linéaire à la position de réception.

5. Procédé selon l'une quelconque des revendications précédentes, caractérisé sn ce que sur les trajets de la première phase de mouvement des composants, un agent de fixation est appliqué simultanément sur tous les composants.

6. Dispositif de mise en oeuvre du procédé selon l'une quelconque des revendications 1 à 5, comportant un châssis, un mécanisme de transfert (25) muni d'organes préhenseurs (30), un mécanisme d'entraînement (27) et un support (7) pour un substrat, caractérisé en ce que le mécanisme de transfert (25) comporte un nombre donné de bras de transfert (23) munis chacun d'un organe préhenseur (30), bras de transfert qui peuvent coulisser les uns par rapport aux autres das des moyens de guidage communs (31), peuvent être déplacés entre une position de réception et une position de montage et coopèrent avec des butées (69, 82) définissant la position de préhension et la position de montage des bras de transfert individuels.

7. Dispositif selon la revendication 6, caractérisé en ce les moyens de guidage communs sont constitués par un chariot (31) qui est couplé au mécanisme d'entraînement (27) et dans lequel les bras de transfert (29) sont logés à coulissement.

8. Dispositif selon l'une des revendications 6 et 7, caractérisé en ce qu'au moins les butées (82) définissant les positions de montage des bras de transfert sont prévues sur une plaque-programme échangeable (71) qui est commune à tous les bras de transfert.

9. Dispositif selon l'une des revendications 6, 7 et 8, caractérisé en ce que les butées (69) définissant les positions de réception des bras de transfert sont disposées de façon permanente et à un écartement régulier sur le châssis.

10. Dispositif selon l'une des revendications 8 et 9, caractérisé en ce que la plaque-programme (71) comporte des guides (83) pour le positionnement des bras de transfert (29) et des organes préhenseurs (30) dans un sens perpendiculaire au sens du movement du chariot (31).

11. Dispositif selon la revendication 10, caractérisé en ce que chaque guide (83) relie une butée (82) sur la plaque-programme à un élément attrapeur (87) du côte d'entrée de la plaque-programme (71), les éléments attrapeurs étant disposés à un écartement régulier.

12. Dispositif selon l'une quelconque des revendications 7 à 12, caractérisé en ce que chacun des organes préhenseurs (30) sur les bras de transfert (29) est muni d'une saillie (67) servant à coopérer avec la plaque-programme.

13. Dispositif selon l'une quelconque des revendications 8 à 12, caractérisé en ce que chaque organe préhenseur comporte une pipette à vide (53) qui est logée à rotation dans un boîtier (103) et qui est couplée à un pignon (105) s'engrenant avec une crémaillère (107) pouvant coopérer avec une butée sur la plaque-programme pour la rotation de la pipette à vide.

14. Dispositif selon l'une quelconque des revendications 6 à 13, caractérisé en ce qu'il comporte un mécanisme (129) d'application d'un agent de fixation sur les composants (5), mécanisme qui comporte un bras allongé (123) muni d'une pluralité de tampons (125), et pouvant être déplacé entre, d'une part, une position de repos dans laquelle les tampons peuvent prendre une quantité d'agent de fixation et, d'autre part, une position de fonctionnement dans laquelle les tampons peuvent être mis en contact avec les faces inférieures des composants saisis (5).

FIG.1

0 071 303

FIG.2

0 071 303

FIG.3

FIG.11

FIG.12

FIG. 4

0 071 303

FIG.5

FIG.6

0 071 303

FIG.7

FIG.9

FIG.8

0 071 303

FIG.10